# FASCICULE DE BREVET EUROPEEN

(11) **EP 4 364 541 B1**
(45) Date de publication et mention de la délivrance du brevet: **14.05.2025**
(21) Numéro de dépôt: 22738045.8
(22) Date de dépôt: 01.07.2022
(51) Int. Cl.: H10N 30/87, B06B 1/06, B05B 17/06

(54) **ÉLÉMENT PIÉZOÉLECTRIQUE POUR NÉBULISATEUR, AVEC UNE DURÉE DE VIE AMÉLIORÉE**
PIEZOELEKTRISCHES ELEMENT FÜR ZERSTÄUBER MIT VERBESSERTER LEBENSDAUER
PIEZOELECTRIC ELEMENT FOR NEBULISER HAVING IMPROVED SERVICE LIFE

(30) Priorité: 01.07.2021 FR 2107162
(43) Date de publication de la demande: 08.05.2024
(73) Titulaire: ARECO FINANCES ET TECHNOLOGIES-ARFITEC, 06130 Grasse (FR)
(72) Inventeur: DECORDE, Nicolas, 06370 Mouans Sartoux (FR); GSCHWIND, Michel, 06130 Plascassier (FR)
(74) Mandataire: IXAS Conseil
(86) Numéro de dépôt international: PCT/IB2022/056149
(87) Numéro de publication internationale: WO 2023/275843

(56) Documents cités:
- DE-A1- 19 820 208
- US-A- 4 746 466

## Description

### DOMAINE TECHNIQUE DE L'INVENTION

L'invention concerne le domaine technique des dispositifs de pulvérisation capables de produire un brouillard de microgouttelettes à partir d'un liquide, et plus particulièrement les dispositifs dans lesquels des microgouttelettes sont générées par un élément piézoélectrique. Plus particulièrement, l'invention concerne un tel dispositif miniaturisé, qui peut être intégré dans un petit volume, et/ou qui permet un dosage très fin de la quantité de brouillard généré.

### ETAT DE LA TECHNIQUE

Les dispositifs de pulvérisation capables de produire un brouillard de micro-gouttelettes à partir d'un liquide par excitation piézoélectrique sont connus en tant que tels. Dans ces systèmes l'élément piézoélectrique peut être associé à une membrane micro-perforée ou à un concentrateur acoustique afin de favoriser la production de brouillard.

On connaît plus particulièrement des dispositifs de nébulisation dans lesquels un élément piézoélectrique en contact avec un volume de liquide génère des ondes ultrasonores qui provoquent la formation d'un brouillard de gouttelettes de très petite taille. Cette taille dépend typiquement de la fréquence acoustique de l'excitation. Elle est typiquement comprise entre 2 µm et 10 µm pour une fréquence acoustique typiquement comprise entre 0,5 MHz et 5 MHz, et diminue lorsque la fréquence acoustique augmente.

De tels dispositifs sont décrits par exemple dans WO 2017/093655 (ARECO). Ils se présentent typiquement sous la forme d'une plaquette cylindrique d'un diamètre circulaire d'environ 5 mm à environ 50 mm et d'une épaisseur d'environ 1 mm à 2 mm.

Ces plaquettes piézoélectriques se trouvent couramment dans le commerce spécialisé, dans différents diamètres et épaisseurs. Elles sont fabriquées par frittage de poudres d'un matériau piézoélectrique. Deux électrodes sont ensuite déposées sur cette plaquette (à savoir : une sur chaque face) pour permettre ultérieurement leur connexion au sein d'un circuit électrique. Avant de pouvoir utiliser ces plaquettes en tant qu'éléments piézoélectriques elles doivent encore subir une forte polarisation sous l'influence d'une tension stationnaire de l'ordre du kilovolt par millimètre carré.

De manière typique, en situation de fonctionnement normal, l'électronique d'un tel élément piézoélectrique est alimentée par une tension continue (par exemple à une tension de 24 V DC). Le signal d'excitation transmis à l'élément piézoélectrique est typiquement composé d'un train d'impulsions composé chacun d'impulsions individuelles à une fréquence proche de la fréquence de résonance de l'élément piézoélectrique, lesdits trains d'impulsions étant espacés dans le temps, cet espacement étant défini par une deuxième fréquence et par un rapport cyclique. Cette modulation est générée par un générateur de fréquence, qui attaque la grille d'un transistor qui produit un signal carré (on/off) périodique de fréquence déterminée ; ce signal est ensuite amplifié par un amplificateur de signal. Ladite fréquence peut être variable et ajustable (typiquement de l'ordre de 1 MHz à 3 Mhz). Le rapport entre les durées « on » et « off » des trains d'impulsions définit la puissance de nébulisation. Le ratio on/off de la haute fréquence (par exemple 1,7 MHz) permet de composer la dissymétrie des composants électroniques et la réponse vibratoire de la plaquette piézoélectrique compte tenu de sa géométrie (y compris la dimension des électrodes). Le signal aux bornes de la plaquette piézoélectrique est donc une sinusoïde générée par l'étage de puissance comme décrit ci-dessus. Tel qu'utilisée dans les dispositifs de nébulisation, son amplitude est typiquement de l'ordre de 70 V.

La puissance crête-à-crête des impulsions peut être élevée. A titre d'exemple, un train d'impulsions individuel peut représenter une puissance comprise entre 30 W et 70 W (cette valeur se réfère à un régime en continu, c'est-à-dire sur 100 % des cycles) pour une surface active d'un diamètre compris entre environ 15 mm et environ 25 mm ; la puissance totale absorbée par le dispositif dépend alors de l'espacement temporel entre deux trains d'impulsions.

Lorsque la surface émettrice de l'élément piézoélectrique est recouverte d'eau, le courant consommé par le dispositif augmente avec la tension appliquée, sur une plage de fonctionnement utile qui est assez large ; à une fréquence proche de la fréquence de résonance l'élément piézoélectrique a un fonctionnement essentiellement résistif.

A titre d'exemple, dans un mode de fonctionnement typique pour une telle plaquette piézoélectrique avec un diamètre de la surface active compris entre environ 10 mm et environ 20 mm, une épaisseur d'environ 1 mm et une fréquence de résonance d'environ 1,7 MHz, l'électronique de pilotage de l'élément piézoélectrique est alimentée avec une tension d'environ 24 V. La consommation électrique en mode continu de l'alimentation est de l'ordre de 2,3 A. Comme cela est décrit dans le document WO 2017/093655 cité ci-dessus de la demanderesse, la zone de fonctionnement du dispositif est assez large et s'étend dans cet exemple de l'ordre de 5 V à environ 40 V ; une zone particulièrement utile se situe entre environ 15 V et environ 30 V. Autrement dit, en fonctionnement normal, une telle plaquette absorbe une puissance de l'ordre de quelques dizaines de Watt, pour une surface de l'ordre de quelques centimètres carré. A titre d'exemple, on utilise une plaquette d'un diamètre de 20 mm dont la surface est de 3,14 cm², qui absorbe une puissance d'environ de 50 W, ce qui correspond à une densité de puissance d'environ 16 W/cm².

On citera également DE 198 20 208 A1, qui concerne un transducteur piézoélectrique du type utilisé pour la propagation des ultrasons, par exemple dans les appareils de mesure acoustique de débit ou les appareils de détection de niveau. Ce transducteur piézoélectrique est constitué d'une céramique piézoélectrique qui possède une première électrode sur une première surface et une seconde électrode sur une surface opposée. Une zone de bord sans électrode, sur laquelle un composant sensible à la température est monté, est disposée sur la première surface de la céramique piézoélectrique. Ce composant est connecté de manière conductrice à au moins une des électrodes.

La demanderesse a constaté que dans les dispositifs de nébulisation industriels, la durée de vie des éléments piézoélectrique est parfois assez limitée. Ils peuvent être remplacés, c'est une opération de routine, mais qui nécessite l'intervention d'un technicien de maintenance spécialisé sur le site d'installation du dispositif de nébulisation (c'est-à-dire par exemple dans un supermarché, si le dispositif est utilisé pour la nébulisation de produits alimentaires frais).

On a constaté que l'on peut diminuer l'usure des plaquettes piézoélectriques en diminuant leur puissance dissipée par unité de surface émettrice. Cependant, on ne souhaite pas que la production de brouillard soit diminuée : diminuer la puissance absorbée du dispositif n'est pas une solution viable. On peut en revanche utiliser une plaquette avec une surface active plus grande pour une puissance de fonctionnement égale, mais cela revient à rendre le dispositif de nébulisation plus encombrant et plus cher, ce qui n'est pas non plus souhaitable.

Le problème que la présente invention cherche à résoudre est de diminuer le taux de défaillance des plaquettes piézoélectriques en service.

### OBJETS DE L'INVENTION

La demanderesse s'est rendu compte qu'un mode de défaillance fréquent est une défaillance au niveau des contacts entre l'élément piézoélectrique et le dispositif de nébulisation dans lequel il est intégré.

De manière typique, l'élément piézoélectrique comprend une plaquette en matériau piézoélectrique dont la face arrière, opposée à la face d'émission acoustique, présente au moins deux zones de contact électrique, qui ont typiquement été déposées par sérigraphie ou par collage d'une feuille métallique ; l'une de ces zones représente un pôle positif, l'autre un pôle négatif. Ces zones peuvent typiquement comprendre une couche métallique sur laquelle on fixe un organe de connexion. Le plus souvent, ledit organe de connexion est un fil électrique qui a été brasé sur ladite couche métallique. On appelle ici « zone de brasage » un point de fixation par lequel un organe de connexion électrique, tel qu'un fil électrique, est fixé sur une couche métallique. Ce point de fixation est le plus souvent réalisé par une technique de brasage appropriée ; le terme « zone de brasage » tel qu'utilisé ici englobe aussi les points de collage, dans le cas où l'organe de connexion a été fixé sur la couche métallique à l'aide d'une colle conductrice. Ces techniques de connexion d'un fils électrique sur une surface conductrice sont connues de l'homme du métier, et ne seront pas expliquées ici en plus grand détail. (Le terme « soudure » est parfois utilisé, improprement, pour désigner ce qui est en réalité un brasage).

La demanderesse s'est rendu compte que dans de nombreux cas, c'est au niveau de cette zone de brasage que le dispositif montre des défaillances précoces, et plus précisément, cette défaillance est observée plus souvent au niveau de la zone de brasage sur l'électrode de phase que sur l'électrode de masse. Sans vouloir être lié par cette théorie, les inventeurs pensent que le passage prolongé d'une forte intensité de courant impulsionnel à haute fréquence à travers une zone de brasage sur une plaquette en vibration fragilise ladite zone de brasage, ce qui conduit à un défaut de contact électrique entre la zone de brasage et la couche métallique déposée par sérigraphie. Ce défaut peut être visible ou non ; il peut s'agir de petites fissures ou d'une rupture franche. Le résultat final est que le dispositif de nébulisation ne fonctionne plus. Ce mode de défaillance compte pour approximativement la moitié des défaillances précoces des plaquettes piézoélectriques que la demanderesse a constatées au fil des années sur des milliers d'installations de nébulisation.

Sachant que lesdites plaquettes piézoélectriques sont des dispositifs qui se trouvent couramment dans le commerce spécialisé, mais dont le prix augmente avec leur diamètre, il n'est ni souhaitable de les agrandir ni de modifier leur forme ou leur structure. La demanderesse n'a pas non plus réussi à résoudre ce problème en cherchant à optimiser le procédé de brasage des éléments de contact ; ni par une amélioration du système de protection de la zone de brasage contre l'humidité ou la sollicitation mécanique.

Selon l'invention, le problème est résolu de manière très simple par une modification des contacts électriques.

Ainsi, un premier objet de l'invention est un élément piézoélectrique pour dispositif d'émission d'ondes acoustiques, ledit élément piézoélectrique comprenant une plaquette en un matériau piézoélectrique, de forme sensiblement cylindrique, d'un diamètre circulaire de préférence compris entre environ 5 mm et environ 100 mm et d'une épaisseur de préférence comprise entre 0,4 mm et 2,0 mm, ladite plaquette comprenant sur une première face, dite « face avant », qui est la face d'émission d'ondes acoustiques, une première couche de conductivité métallique capable d'agir comme première électrode, formant un disque et s'étendant sur au moins 50 %, de préférence au moins 70 %, et encore plus préférentiellement au moins 80 % de la superficie de ladite face avant,
et ladite plaquette comprenant sur une deuxième face, dite « face arrière », une deuxième couche de conductivité métallique capable d'agir comme deuxième électrode et s'étendant sur au moins 10 %, de préférence au moins 20 % et encore plus préférentiellement au moins 50 % de la superficie de ladite face arrière,
ledit élément piézoélectrique étant caractérisé en ce que :
   ladite deuxième électrode forme un disque comportant, sur ladite deuxième face, au moins deux deuxièmes zones de prolongement s'étendant chacune dans une direction radiale. L'élément piézoélectrique selon l'invention comprend au moins trois éléments de connexion électrique, à savoir un fil fixé sur chacune des deux deuxièmes zones de prolongement (ou sur au moins deux des deuxièmes zones de prolongement), et un fil fixé sur ladite première électrode, de préférence sur une zone de brasage. Plus particulièrement, il peut comprendre au moins trois éléments de connexion électrique, à savoir un fil fixé sur chacune des deux deuxièmes zones de prolongement, et un fil fixé sur ladite première zone de prolongement.

Selon des modes de réalisation préférés :
- Ladite plaquette cylindrique présente un diamètre circulaire compris entre environ 10 mm et environ 50 mm ;
- Ladite plaquette cylindrique présente une épaisseur comprise entre environ 0,5 mm et environ 2,0 mm, et de préférence entre environ 1 mm et environ 2 mm ;
- Ladite deuxième couche de conductivité métallique capable d'agir comme deuxième électrode s'étend sur au moins 60 % de la superficie de ladite face arrière.

De manière typique, ladite plaquette comprend en outre une première zone de prolongement de ladite première électrode qui s'étend sur la tranche de ladite plaquette ainsi que sur une portion périphérique de ladite deuxième face.

Selon d'autres aspects de l'invention, l'élément piézo-électrique selon l'invention comprend, sur chacune des zones de prolongement de ladite deuxième électrode, une zone de brasage par laquelle est fixé un élément de connexion électrique tel qu'un fil.

Selon un autre aspect de l'invention, l'élément piézoélectrique comprend encore un premier revêtement de protection appliqué sur la face avant, et un deuxième revêtement de protection appliqué sur la face arrière, chacun de ces revêtements de protection recouvrant lesdites couches de conductivité métallique et, le cas échéant, lesdites zones de brasage.

L'élément piézoélectrique selon l'invention peut comprendre des éléments de connexion électrique, qui sont tous fixés sur la face arrière de ladite plaquette.

De manière avantageuse, l'élément piézoélectrique selon l'invention peut comprendre encore un joint périphérique souple capable de protéger la tranche de ladite plaquette ; cela facilite son intégration dans un dispositif de nébulisation.

Un autre objet de l'invention est l'utilisation d'un élément piézoélectrique selon l'une quelconque des modes de réalisation ou variantes de l'invention dans un dispositif de nébulisation.

### FIGURES

La figure 1 se rapporte à l'état de la technique, alors que les figures 2 à 5 illustrent des modes de réalisation de l'invention.
[Fig. 1] montre de manière schématique une séquence d'étapes de fabrication d'une plaquette piézo-électrique selon l'état de la technique.
[Fig. 2] montre de manière schématique la face arrière d'un élément piézoélectrique selon un premier mode de réalisation de l'invention.
[Fig. 3] montre de manière schématique deux vues d'un élément piézoélectrique selon un premier mode de réalisation de l'invention, à savoir une vue frontale de la face arrière (en bas) et une section transversale (en haut).
[Fig. 4] montre de manière schématique la face arrière d'un élément piézoélectrique selon un deuxième mode de réalisation de l'invention.
[Fig. 5] montre de manière schématique la face arrière d'un élément piézoélectrique selon un autre mode de réalisation de l'invention.

Les repères numériques suivants sont utilisés sur les figures et dans la description qui suit :
- 1;21;41;61: Plaquette piézoélectrique
- 2;42: Première électrode (masse)
- 3;23,43: Zone de prolongement de la première électrode
- 4;24;44: Deuxième électrode (phase)
- 5: Premier revêtement de protection
- 6: Source de haute tension stationnaire (DC)
- 7,8: Premier et deuxième fil de connexion
- 9,10: Première et deuxième zone de brasage
- 11: Deuxième revêtement de protection
- 12: Impression de la référence
- 28,58: Fil de connexion électrique (masse)
- 33,34;52,53,54: Zones de prolongement de la deuxième électrode
- 35,36;55,56,57: Fil de connexion électrique (électrode phase)
- 62: Joint
- 63: Tube

### DESCRIPTION DETAILLEE

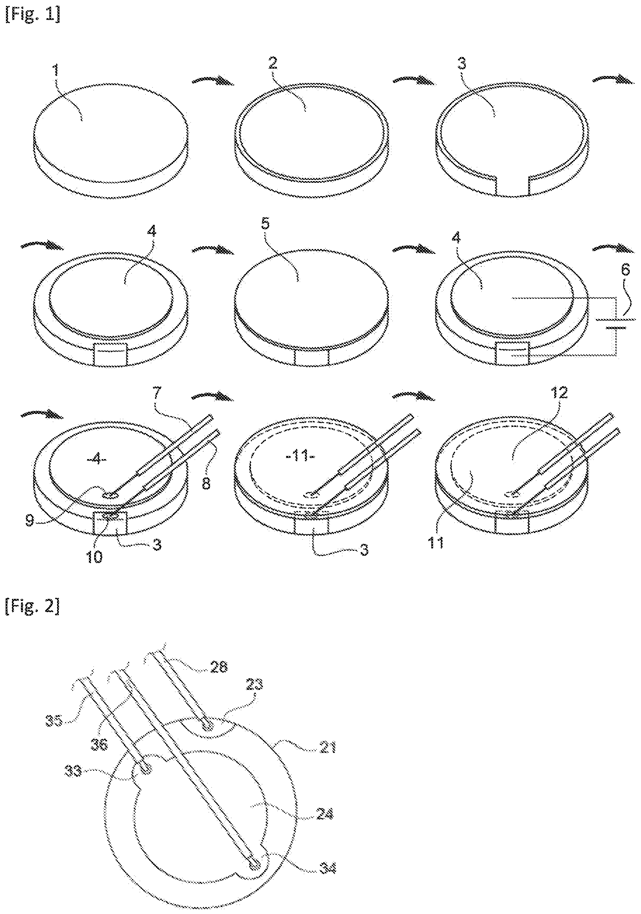

La figure 1 illustre l'état de la technique et montre de manière schématique la fabrication d'un élément piézoélectrique prêt à être intégré dans un dispositif de nébulisation à partir d'une plaquette fabriquée par frittage d'une poudre d'un matériau piézoélectrique.

On approvisionne une plaquette 1 d'une matériau piézoélectrique, on dépose sur une première face (appelée ici « face avant ») une première électrode 2 (en l'occurrence l'électrode de masse), on dépose sur la tranche de la plaquette 1 une zone de prolongement 3 de ladite première électrode 2 (cette zone de prolongement étant couramment appelé « wrap-up électrode »), on dépose sur la deuxième face (appelée ici « face arrière ») de la plaquette une deuxième électrode 4 (en l'occurrence l'électrode de phase), et on dépose sur ladite première électrode un premier revêtement de protection 5.

Dans le mode de réalisation avantageux de l'état de la technique montré sur cette figure 1, ladite zone de prolongement 3 de ladite première électrode s'étend sur une portion périphérique de ladite deuxième face. Cela permet de prendre le contact de la première électrode sur la deuxième face de la plaquette.

Ensuite on polarise la plaquette piézoélectrique par l'application d'une forte tension stationnaire **6** (de l'ordre du kilovolt par millimètre). Ensuite on fixe (typiquement par brasage) sur la deuxième électrode **4** ainsi que sur la zone de prolongement **3** de la première électrode un premier et deuxième fil de connexion **7**,**8**, sachant qu'il est avantageux que les points de brasage **9,10** de ces deux fils de connexion **7**,**8** se trouvent sur la même face de la plaquette **1**. Cela facilite le câblage lorsque la plaquette piézoélectrique est montée dans un dispositif de nébulisation, et cela évite d'avoir à faire passer un fil de connexion dans l'eau tout en assurant une bonne étanchéité dudit dispositif de nébulisation.

Ensuite on dépose sur la deuxième électrode **4** ainsi que sur la zone de prolongement **3** un deuxième revêtement de protection **11** ; ce revêtement recouvre également les zones de brasage **9**,**10**. La fabrication se termine typiquement avec l'écriture de la référence de produit **12** sur l'un des revêtements de protection ; cela peut se faire par jet d'encre.

En ce qui concerne lesdits revêtements de protection, on utilise avantageusement sur la face avant un vernis recuit à haute température ou un verre. Cependant, on ne peut pas faire cela sur la face arrière car la haute température dépolariserait la céramique qui a été polarisée justement après le recuit du vernis de la face avant ; on applique donc sur la face arrière un simple vernis qui sèche ou réticule à la température ambiante ou à une température très modérée.

Cet élément piézoélectrique est alors prêt à être utilisé dans des dispositifs électrotechniques comme émetteur d'ultrasons. L'émission des ultrasons se fait par la face avant, la face arrière servant à la connexion électrique. Comme cela est visible sur la figure 1, ladite première et deuxième électrode ont chacune la forme d'un disque de forme sensiblement circulaire.

Comme indiqué ci-dessus, c'est au niveau des contacts électriques que l'invention apporte une modification à la structure du dispositif et à son procédé de fabrication. La figure 2 illustre de manière schématique un mode de réalisation de l'invention. Elle montre la face arrière d'une plaquette piézoélectrique **21** avec sa deuxième électrode **24** (en l'occurrence la phase) et la zone de prolongement **23** de la première électrode (déposée sur la face avant de plaquette, non visible sur la figure) qui a été déposée sur la tranche de la plaquette. Ladite zone de prolongement de la première électrode sert comme zone de contact pour un premier fil de connexion.

Selon l'invention, ladite deuxième électrode **24** forme un disque qui comporte au moins deux zones de prolongement **33,34** sur la deuxième face. Lesdites zones de prolongement **33,34** s'étendent chacune dans une direction sensiblement radiale. Sur chacune de ces zones de prolongement **33,34** est fixé un fil de connexion électrique **35**,**36.** Ladite deuxième électrode est la phase. Ainsi, le courant de l'électrode de phase est réparti sur deux connexions. La demanderesse a constaté que cela diminue le taux de défaillance des connexions ainsi que le nombre de connexions défaillantes. Cela est surprenant dans la mesure où dans l'élément piézoélectrique selon l'invention, le nombre de connexions électriques est augmenté, ce qui serait susceptible d'augmenter le nombre de défaillances. Il semble que le taux de défaillance des éléments piézoélectriques soit directement lié à la quantité de courant (exprimée en Ampères) qui passe par un point de brasage. On constate que pour un élément piézoélectrique selon l'invention, la durée de vie moyenne est augmentée d'environ 30 % du fait de la diminution du courant de l'électrode de phase à travers les connexions ; ce chiffre a été établi comme valeur moyenne pour un nombre significatif de plaquettes.

Par ailleurs, on observe que dans le cas où dans l'élément piézo-électrique selon l'invention une connexion vient à être défaillante, la présence d'un deuxième point de connexion sur l'électrode de phase prolonge la durée de vie de cet élément piézoélectrique.

La demanderesse a observé que cet effet du nombre de points de connexion sur la durée de vie de l'élément piézoélectrique ne se montre que pour l'électrode de phase. Les défaillances de la connexion à l'électrode de masse sont en tous les cas rares. Par rapport à la contrainte de devoir dupliquer les connexions positives (ce qui engendre un surcoût lors de la fabrication de la plaquette et lors de son câblage) la duplication des connexions de masse ne présente pas d'intérêt significatif.

La face arrière de la plaquette montrée sur la figure 2 peut ensuite recevoir un revêtement, comme cela a été expliqué en relation avec la figure 1.

Dans un mode de réalisation particulier, comme montré sur la figure 2, les zones de prolongement **33,34** se situent en positions opposées sur l'électrode de phase **24** (par exemple à des positions radiales qui diffèrent d'environ 140° à 220°, et plus spécialement d'environ 180°, comme sur la figure). Cette dernière présente avantageusement (et de manière connue en tant que telle) la forme d'un disque circulaire dans le cas où la plaquette piézoélectrique **21** présente une forme de disque circulaire. Afin de pouvoir donner une superficie aussi grande que possible à l'électrode de phase **44**, le point de connexion **33** le plus proche sur cette électrode de phase par rapport à la zone de prolongement **23** de l'électrode de masse se situe en décalage par rapport à ce dernier (par exemple à environ 45°).

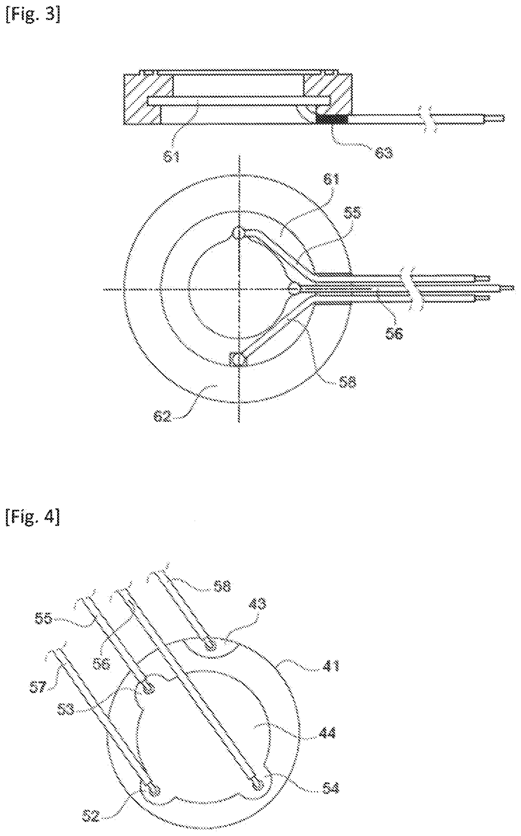

Dans un autre mode de réalisation, montré sur la figure 3, les zones de prolongement se situent à des positions radiales d'environ 90° (± 30°) et 180° (±30°) par rapport à la zone de prolongement de l'électrode de masse. Le mode de réalisation montré sur cette figure comporte deux autres caractéristiques avantageuses qui sont compatibles avec tous les modes de réalisation de la présente invention. La plaquette **61**, après avoir reçu les revêtements de protection (non montrés sur cette figure) sur la première et deuxième électrode, est entourée d'un joint souple **62**, par exemple en silicone. Ce joint protège la tranche de la plaquette, et il peut également servir comme élément d'étanchéité dans le dispositif (par exemple un dispositif de nébulisation) dans lequel est incorporé ledit élément piézo-électrique.

Par ailleurs, un tube **63** souple ou semi-rigide réunit les trois fils électriques pour éviter leur déplacement incontrôlé qui peut conduire à leur arrachement. Dans le mode de réalisations selon la figure 3, ce tube **63** assure le passage des fils à travers le joint.

Dans un autre mode de réalisation de l'invention, montré sur la figure 4, on utilise trois points de connexion sur l'électrode de phase **44**. Cette deuxième électrode **44** présente donc trois zones de prolongement **52**,**53**,**54.** Par rapport au mode de réalisation avec deux connexions de la figure 2, on n'a pas constaté une diminution supplémentaire du taux de défaillance qui serait significative ; le surcoût de cette solution ne se justifie que dans des cas particuliers.

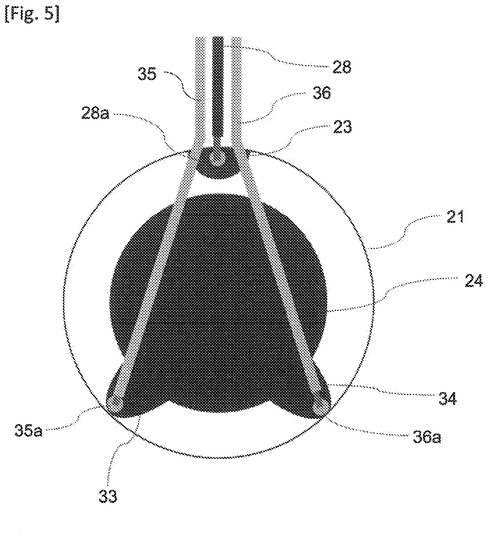

Dans encore un autre mode de réalisation de l'invention, montré sur la figure 5, les zones de brasage **35a**,**36a** des fils de connexion électrique sur les zones de prolongement **33**,**34** de la deuxième électrode se trouvent très proches du bord de la plaquette piézoélectrique **21**, et de préférence le centre desdits zones de brasage **35a,36a** se trouve à une distance de moins de 10 % du diamètre de la plaquette **21**, et de préférence à une distance de moins de 5 % du diamètre de la plaquette **21**, ou à une distance inférieure à 3 mm, et de préférence à une distance inférieure à 2 mm. Les zones de prolongement **33,34** sur lesquelles sont apportées ces zones de brasage **35a**,**36a** peuvent être très proches du bord de la plaquette **21**, ou peuvent même touche le bord de la plaquette **21**, comme cela est visible sur la figure 5. Il est entendu que ces zones de brasage **35a**,**36a** fixent les fils de connexion **35**,**36** de l'électrode phase. De manière optionnelle, la même disposition peut être choisie pour le centre de la zone de brasage **28a** du fils de connexion **28** de l'électrode masse, comme cela est montré sur la figure 5, et dans ce cas la zone de prolongement **23** de la première électrode peut être très proche du bord de la plaquette **21**, ou peut même touche le bord de la plaquette **21**.

Les inventeurs ont constaté que le fait de positionner les zones de brasage aussi proche que possible du bord de la plaquette diminue le taux de défaillance des connexions par brasure ; cela est probablement lié au fait que plus on s'éloigne du centre de la plaquette, plus l'amplitude de vibration est faible.

Ce mode de réalisation peut être mis en oeuvre également dans le cas où on utilise trois fils de phase, comme sur la figure 4.

L'invention s'applique en particulier aux systèmes de nébulisation destinés à générer un brouillard dit sec avec une taille de gouttelettes typiquement comprise entre environ 1 µm et environ 10 µm. Elle est avantageusement réalisée avec des éléments piézoélectriques présentant la forme d'une plaquette cylindrique, dont le diamètre circulaire est compris entre environ 10 mm et environ 30 mm, de préférence entre environ 12 mm et environ 25 mm, et encore plus préférentiellement entre 12 mm et 25 mm. Leur épaisseur détermine leur fréquence de résonance ; elle est avantageusement comprise entre environ 0,5 mm et environ 2 mm, de préférence entre environ 0,8 mm et environ 1,3 mm. Dans un mode de réalisation avantageux, la plaquette présente un diamètre circulaire compris entre 15 mm et 25 mm et une épaisseur comprise entre 0,5 mm et 2,0 mm, et de préférence entre 0,6 mm et 1,7 mm.

A titre d'exemple, pour une épaisseur d'environ 1 mm la fréquence de résonance est de l'ordre de 1,7 MHz. Pour une épaisseur plus grande la fréquence de résonance diminue, alors que pour une épaisseur plus faible elle augmente. Un tel élément piézoélectrique d'un diamètre de 20 mm peut absorber un courant qui se situe typiquement entre environ 2 A et environ 2,5 A, la puissance absorbée étant de l'ordre de 40 W à 50 W. D'une manière générale, pour utilisation dans un dispositif de nébulisation on choisit avantageusement un élément piézo-électrique avec une fréquence d'émission acoustique comprise entre 0,5 MHz et 10 MHz.

## Revendications

1. Elément piézoélectrique pour dispositif d'émission d'ondes acoustiques, ledit élément piézoélectrique comprenant une plaquette (1,21,41,61) en un matériau piézoélectrique, de forme sensiblement cylindrique, de préférence d'un diamètre circulaire compris entre 5 mm et 100 mm, et de préférence entre 10 mm et 50 mm, et de préférence d'une épaisseur comprise entre 0,4 mm et 2,0 mm, et encore plus préférentiellement entre 0,5 mm et 2,0 mm, ladite plaquette comprenant sur une première face, dite « face avant », qui est la face d'émission d'ondes acoustiques, une première couche de conductivité métallique capable d'agir comme première électrode (2,42), formant un disque et s'étendant sur au moins 50 %, et de préférence au moins 70 % de la superficie de ladite face avant,
ladite plaquette (1,21,41,61) comprenant sur une deuxième face, dite « face arrière », une deuxième couche de conductivité métallique capable d'agir comme deuxième électrode (4,24,44) et s'étendant sur au moins 10 %, de préférence au moins 20 %, et encore plus préférentiellement au moins 50 % de la superficie de ladite face arrière, et ladite deuxième électrode (4,24,44) formant un disque comportant, sur ladite deuxième face, au moins deux deuxièmes zones de prolongement (33,34 ;52,53,54) s'étendant chacune dans une direction radiale,
ledit élément piézoélectrique étant **caractérisé en ce qu'**il comprend au moins trois éléments de connexion électrique, à savoir au moins deux fils (35,36;55,56,57) fixés sur au moins deux des deuxièmes zones de prolongement (33,34;52,53,54), et un fil (28,58) fixé sur ladite première électrode (2;42), lesdits éléments de connexion électrique étant fixés de préférence par une zone de brasage.

2. Elément piézoélectrique selon la revendication 1, **caractérisé en ce que** ladite plaquette (1,21,41,61) présente un diamètre circulaire compris entre 12 mm et 25 mm, et une épaisseur comprise entre 0,5 mm et 2,0 mm, et de préférence un diamètre circulaire comprise entre 15 mm et 25 mm et une épaisseur comprise entre 0,6 mm et 1,7 mm.

3. Elément piézoélectrique selon la revendication 1 ou 2, **caractérisé en ce que** ladite plaquette (1,21,41,61) comprend en outre une première zone de prolongement (3,23,43) de ladite première électrode (2,42) qui s'étend sur la tranche de ladite plaquette (1,21,41,61) ainsi que sur une portion périphérique de ladite deuxième face.

4. Elément piézoélectrique selon l'une quelconque des revendications 1 à 3, **caractérisé en ce qu'**il comprend, sur chacune des zones de prolongement (33,34;52,53,54) de ladite deuxième électrode (4,24,44), une zone de brasage par laquelle est fixé un élément de connexion électrique tel qu'un fil.

5. Elément piézoélectrique selon l'une quelconque des revendications 1 à 4, **caractérisé en ce que** le centre de ladite zone de brasage (35a,35b) sur lesdites deuxièmes zone de prolongement (33,34) se trouve à une distance de moins de 10% du diamètre de la plaquette (21), et de préférence à une distance de moins de 5 % du diamètre de la plaquette (21), ou à une distance inférieure à 3 mm, et de préférence à une distance inférieure à 2 mm.

6. Elément piézoélectrique selon l'une quelconque des revendications 3 à 5, **caractérisé en ce qu'**il comprend au moins trois éléments de connexion électrique, à savoir un fil (35,36;55,56,57) fixé sur chacune des deux deuxièmes zones de prolongement (33,34;52,53,54), et un fil (28,58) fixé sur ladite première zone de prolongement (3 ;23,43).

7. Elément piézoélectrique selon l'une quelconque des revendications 3 à 6, **caractérisé en ce qu'**il comprend encore un premier revêtement (5) de protection appliqué sur la face avant, et un deuxième revêtement (11) de protection appliqué sur la face arrière, chacun de ces revêtements de protection recouvrant lesdites couches de conductivité métallique et, le cas échéant, lesdites zones de brasage.

8. Elément piézoélectrique selon l'une quelconque des revendications 1 à 7, **caractérisé en ce qu'**il comprend des éléments de connexion électrique, qui sont tous fixés sur la face arrière de ladite plaquette.

9. Elément piézoélectrique selon l'une quelconque des revendications 1 à 8, **caractérisé en ce qu'**il comprend encore un joint périphérique souple (62) capable de protéger la tranche de ladite plaquette.

10. Elément piézoélectrique selon l'une quelconque des revendications 1 à 9, **caractérisé en ce qu'**il présente une fréquence d'émission acoustique comprise entre 0,5 MHz et 10 MHz.

11. Elément piézoélectrique selon l'une quelconque des revendications 1 à 10, **caractérisé en ce que** ladite première électrode (2) est la masse, et ladite deuxième électrode (4,24,44) est la phase.

12. Utilisation d'un élément piézoélectrique selon l'une quelconque des revendications 1 à 11 dans un dispositif de nébulisation.

## Patentansprüche

1. Piezoelektrisches Element für eine Vorrichtung zum Aussenden von akustischen Wellen, wobei das piezoelektrische Element ein Plättchen (1, 21, 41, 61) aus einem piezoelektrischen Material umfasst, das im Wesentlichen zylindrisch geformt ist, vorzugsweise einen kreisförmigen Durchmesser zwischen 5 mm und 100 mm und vorzugsweise zwischen 10 mm und 50 mm hat und vorzugsweise eine Dicke zwischen 0,4 mm und 2,0 mm hat, und noch bevorzugter zwischen 0,5 mm und 2,0 mm, wobei das Plättchen auf einer ersten Seite, der sogenannten "Vorderseite", die die Emissionsseite für akustische Wellen ist, eine erste metallische Leitfähigkeitsschicht umfasst, die als erste Elektrode (2, 42) wirken kann, eine Scheibe bildet und sich über mindestens 50 %, vorzugsweise mindestens 70 % der Fläche der Vorderseite erstreckt,
wobei dieses Plättchen (1, 21, 41, 61) auf einer zweiten Seite, der sogenannten "Rückseite", eine zweite metallische Leitfähigkeitsschicht aufweist, die als zweite Elektrode (4, 24, 44) wirken kann und sich über mindestens 10 %, vorzugsweise mindestens 20 % und noch bevorzugter mindestens 50 % der Fläche der Rückseite erstreckt, und
wobei die zweite Elektrode (4, 24, 44) eine Scheibe bildet, die auf der zweiten Seite mindestens zwei zweite Verlängerungsbereiche (33, 34; 52, 53, 54) aufweist, die sich jeweils in einer radialen Richtung erstrecken,
wobei das piezoelektrische Element **dadurch gekennzeichnet ist, dass** es mindestens drei elektrische Verbindungselemente umfasst, nämlich mindestens zwei Drähte (35,36;55,56,57), die an mindestens zwei der zweiten Verlängerungsbereiche (33,34;52,53,54) befestigt sind, und einen Draht (28,58), der an der ersten Elektrode (2;42) befestigt ist, wobei die elektrischen Verbindungselemente vorzugsweise durch einen Lötbereich befestigt sind.

2. Piezoelektrisches Element nach Anspruch 1, **dadurch gekennzeichnet, dass** das Plättchen (1, 21, 41, 61) einen kreisförmigen Durchmesser zwischen 12 mm und 25 mm und eine Dicke zwischen 0,5 mm und 2,0 mm aufweist, und vorzugsweise einen kreisförmigen Durchmesser zwischen 15 mm und 25 mm und eine Dicke zwischen 0,6 mm und 1,7 mm aufweist.

3. Piezoelektrisches Element nach Anspruch 1 oder 2, **dadurch gekennzeichnet, dass** das Plättchen (1, 21, 41, 61) außerdem einen ersten Verlängerungsbereich (3, 23, 43) der ersten Elektrode (2, 42) umfasst, der sich über die Kante des Plättchens (1, 21, 41, 61) sowie über einen Umfangsabschnitt der zweiten Seite erstreckt.

4. Piezoelektrisches Element nach einem der Ansprüche 1 bis 3, **dadurch gekennzeichnet, dass** es an jedem der Verlängerungsbereiche (33, 34; 52, 53, 54) der zweiten Elektrode (4, 24, 44) einen Lötbereich aufweist, durch den ein elektrisches Verbindungselement wie ein Draht befestigt ist.

5. Piezoelektrisches Element nach einem der Ansprüche 1 bis 4, **dadurch gekennzeichnet, dass** die Mitte des Lötbereichs (35a, 35b) auf den zweiten Verlängerungsbereichen (33, 34) in einem Abstand von weniger als 10 % des Durchmessers des Plättchen (21), vorzugsweise in einem Abstand von weniger als 5 % des Durchmessers des Plättchen (21), oder in einem Abstand von weniger als 3 mm, vorzugsweise in einem Abstand von weniger als 2 mm, angeordnet ist.

6. Piezoelektrisches Element nach einem der Ansprüche 3 bis 5, **dadurch gekennzeichnet, dass** es mindestens drei elektrische Verbindungselemente umfasst, nämlich einen Draht (35,36;55,56,57), der an jedem der beiden zweiten Verlängerungsbereiche (33,34;52,53,54) befestigt ist, und einen Draht (28,58), der an dem ersten Verlängerungsbereich (3;23,43) befestigt ist.

7. Piezoelektrisches Element nach einem der Ansprüche 3 bis 6, **dadurch gekennzeichnet, dass** es weiterhin eine erste, auf der Vorderseite aufgebrachte Schutzbeschichtung (5) und eine zweite, auf der Rückseite aufgebrachte Schutzbeschichtung (11) umfasst, wobei jede dieser Schutzbeschichtungen die metallischen Leitfähigkeitsschichten und gegebenenfalls die Lötbereiche bedeckt.

8. Piezoelektrisches Element nach einem der Ansprüche 1 bis 7, **dadurch gekennzeichnet, dass** es elektrische Verbindungselemente umfasst, die alle an der Rückseite des Plättchens befestigt sind.

9. Piezoelektrisches Element nach einem der Ansprüche 1 bis 8, **dadurch gekennzeichnet, dass** es noch eine flexible Umfangsdichtung (62) umfasst, die in der Lage ist, die Kante des Plättchens zu schützen.

10. Piezoelektrisches Element nach einem der Ansprüche 1 bis 9, **dadurch gekennzeichnet, dass** es eine akustische Emissionsfrequenz zwischen 0,5 MHz und 10 MHz aufweist.

11. Piezoelektrisches Element nach einem der Ansprüche 1 bis 10, **dadurch gekennzeichnet, dass** die erste Elektrode (2) die Masse ist und die zweite Elektrode (4, 24, 44) die Phase ist.

12. Verwendung eines piezoelektrischen Elements nach einem der Ansprüche 1 bis 11 in einer Vernebelungsvorrichtung.

## Claims

1. A piezoelectric element for an acoustic wave emitting device, said piezoelectric element comprising a plate (1, 21, 41, 61) made of a piezoelectric material, of substantially cylindrical shape, preferably with a circular diameter of between 5 mm and 100 mm, and preferably between 10 mm and 50 mm, and preferably with a thickness of between 0.4 mm and 2.0 mm, and even more preferably between 0.5 mm and 2.0 mm, said plate comprising on a first face, referred to as the 'front face', which is the acoustic wave emission face, a first layer of metallic conductivity capable of acting as a first electrode (2, 42), forming a disc and extending over at least 50%, and preferably at least 70%, of the surface area of the said front face,
said plate (1, 21, 41, 61) comprising on a second face, referred to as the 'rear face', a second layer of metallic conductivity capable of acting as a second electrode (4, 24, 44) and extending over at least 10%, preferably at least 20%, and even more preferably at least 50% of the surface area of said rear face, and said second electrode (4, 24, 44) forming a disc comprising, on said second face, at least two second extension zones (33, 34; 52, 53, 54) each extending in a radial direction,
said piezoelectric element being **characterized in that** it comprises at least three electrical connection elements, namely at least two wires (35, 36; 55, 56, 57) fixed to at least two of the second extension zones (33, 34; 52, 53, 54), and a wire (28, 58) fixed to said first electrode (2; 42), said electrical connection elements preferably being fixed by a welding zone.

2. A piezoelectric element according to claim 1, **characterized in that** said plate (1, 21, 41, 61) has a circular diameter of between 12 mm and 25 mm, and a thickness of between 0.5 mm and 2.0 mm, and preferably a circular diameter of between 15 mm and 25 mm and a thickness of between 0.6 mm and 1.7 mm.

3. A piezoelectric element according to claim 1 or 2, **characterized in that** said plate (1, 21, 41, 61) further comprises a first extension zone (3, 23, 43) of said first electrode (2, 42) which extends over the edge of said plate (1, 21, 41, 61) as well as over a peripheral portion of said second face.

4. A piezoelectric element according to any one of claims 1 to 3, **characterized in that** it comprises, on each of the extension zones (33, 34; 52, 53, 54) of said second electrode (4, 24, 44), a welding zone by means of which an electrical connection element such as a wire is fixed.

5. Piezoelectric element according to any one of claims 1 to 4, **characterized in that** the centre of said welding zone (35a, 35b) on said second extension zone (33, 34) is at a distance of less than 10% of the diameter of the plate (21), and preferably at a distance of less than 5% of the diameter of the plate (21), or at a distance of less than 3 mm, and preferably at a distance of less than 2 mm.

6. Piezoelectric element according to any one of claims 3 to 5, **characterized in that** it comprises at least three electrical connection elements, namely a wire (35, 36; 55, 56, 57) fixed to each of the two second extension zones (33, 34; 52, 53, 54), and a wire (28, 58) fixed to the said first extension zone (3; 23, 43).

7. Piezoelectric element according to any one of claims 3 to 6, **characterized in that** it also comprises a first protective coating (5) applied to the front face, and a second protective coating (11) applied to the rear face, each of these protective coatings covering said layers of metallic conductivity and, where appropriate, the said welding zones.

8. Piezoelectric element according to any one of claims 1 to 7, **characterized in that** it comprises electrical connection elements, all of which are fixed to the rear face of said plate.

9. Piezoelectric element according to any one of claims 1 to 8, **characterized in that** it further comprises a flexible peripheral seal (62) capable of protecting the edge of said plate.

10. Piezoelectric element according to any one of claims 1 to 9, **characterized in that** it has an acoustic emission frequency of between 0.5 MHz and 10 MHz.

11. Piezoelectric element according to any one of claims 1 to 10, **characterized in that** said first electrode (2) is ground, and said second electrode (4, 24, 44) is the phase.

12. Use of a piezoelectric element according to any one of claims 1 to 11 in a nebulization device.
